# EUROPÄISCHE PATENTSCHRIFT

(11) **EP 2 859 620 B1**
(45) Veröffentlichungstag und Bekanntmachung des Hinweises auf die Patenterteilung: **03.08.2016**
(21) Anmeldenummer: 13725113.8
(22) Anmeldetag: 16.05.2013
(51) Int. Cl.: H01R 4/58, H01R 13/11, H05B 3/84, B32B 17/10, C03C 27/12, C03C 17/22, H01Q 1/12

(54) **SCHEIBE MIT EINEM ELEKTRISCHEN ANSCHLUSSELEMENT**
PANE HAVING AN ELECTRICAL CONNECTION ELEMENT
VITRE DOTÉE D'UN ÉLÉMENT DE RACCORDEMENT ÉLECTRIQUE

(30) Priorität: 06.06.2012 EP 12171029
(43) Veröffentlichungstag der Anmeldung: 15.04.2015
(73) Patentinhaber: Saint-Gobain Glass France, 92400 Courbevoie (FR)
(72) Erfinder: SCHMALBUCH, Klaus, 52074 Aachen (DE); REUL, Bernhard, 52134 Herzogenrath (DE); LESMEISTER, Lothar, NL-6373 Landgraaf (NL); RATEICZAK, Mitja, 52146 Würselen (DE)
(74) Vertreter: Gebauer, Dieter Edmund
(86) Internationale Anmeldenummer: PCT/EP2013/060116
(87) Internationale Veröffentlichungsnummer: WO 2013/182394

(56) Entgegenhaltungen:
- EP-A1- 0 593 940
- EP-A1- 2 365 730
- EP-A1- 2 408 260
- US-A1- 2003 162 415
- US-A1- 2006 102 610
- US-A1- 2007 224 842
- "8.1.7 Wärmeausdehnung" In: Menges Georg, Haberstroh Edmund, Michaeli Walter, Schmachtenberg Ernst: "Werkstoffkunde Kunststoffe", 2002, Carl Hanser Verlag München Wien,, XP002686076, ISBN: 978-3-446-21257-2 Seite 257, Seite 257; Abbildung 8.16

## Beschreibung

Die Erfindung betrifft eine Scheibe mit einem elektrischen Anschlusselement und ein wirtschaftliches und umweltfreundliches Verfahren zu deren Herstellung.

Die Erfindung betrifft weiter eine Scheibe mit einem elektrischen Anschlusselement für Fahrzeuge mit elektrisch leitfähigen Strukturen wie beispielsweise Heizleiter oder Antennenleiter. Die elektrisch leitfähigen Strukturen sind üblicherweise über angelötete elektrische Anschlusselemente mit der Bordelektrik verbunden. Aufgrund unterschiedlicher thermischer Ausdehnungskoeffizienten der verwendeten Materialien treten mechanische Spannungen bei der Herstellung und im Betrieb auf, welche die Scheiben belasten und den Bruch der Scheibe hervorrufen können.

Bleihaltige Lote weisen eine hohe Duktilität auf, die auftretende mechanische Spannungen zwischen elektrischem Anschlusselement und der Scheibe durch plastische Deformierung kompensieren können. Allerdings müssen aufgrund der Altauto-Richtlinie 2000/53/EG innerhalb der EG bleihaltige Lote durch bleifreie Lote ersetzt werden. Die Richtlinie wird zusammenfassend mit dem Kürzel ELV (End of life vehicles) bezeichnet. Das Ziel ist dabei, im Zuge der massiven Ausweitung von Wegwerfelektronik äußerst problematische Bestandteile aus den Produkten zu verbannen. Die betroffenen Substanzen sind Blei, Quecksilber und Cadmium. Das betrifft unter anderem die Durchsetzung von bleifreien Lötmitteln in elektrischen Anwendungen auf Glas und die Einführung entsprechender Ersatzprodukte hierzu.

Elektrische Anschlusselemente, welche als Druckknopf ausgestaltet sind, sind beispielsweise aus US 6249966 B1 und US 20070224842 A1 bekannt. Solche Anschlusselemente ermöglichen einen komfortablen Anschluss an die Bordelektrik. In US 20070224842 A1 wird vorgeschlagen, das Anschlusselement aus Titan zu fertigen. Titan ist allerdings schlecht lötbar. Dies führt zu einer schlechten Haftung des Anschlusselementes an der Scheibe. Titan ist zudem sehr teuer, was zu einem hohen Preis für das Anschlusselement führt.

Die Aufgabe der vorliegenden Erfindung ist es, eine Scheibe mit einem elektrischen Anschlusselement und ein wirtschaftliches und umweltfreundliches Verfahren zu deren Herstellung bereitzustellen, wobei kritische mechanische Spannungen in der Scheibe vermieden werden.

Die Aufgabe der vorliegenden Erfindung ist weiter, ein im Vergleich zum Stand der Technik verbessertes Material für das Anschlusselement bereitzustellen, welches eine bessere Verfügbarkeit und bessere Verarbeitbarkeit, wie Lötbarkeit und Kaltumformbarkeit hat.

Die Aufgabe der vorliegenden Erfindung wird erfindungsgemäß durch eine Vorrichtung gemäß dem unabhängigen Anspruch 1 gelöst. Bevorzugte Ausführungen gehen aus den Unteransprüchen hervor.

Die erfindungsgemäße Scheibe mit mindestens einem Anschlusselement umfasst die folgenden Merkmale:
- ein Substrat,
- eine elektrisch leitfähige Struktur auf einem Bereich des Substrats,
- ein Anschlusselement, welches als Druckknopf ausgebildet ist und zumindest einen chromhaltigen Stahl enthält, und
- eine Schicht einer Lotmasse, die das Anschlusselement zumindest mit einem Teilbereich der elektrisch leitfähigen Struktur elektrisch verbindet.

Das Substrat enthält bevorzugt Glas, besonders bevorzugt Flachglas, Floatglas, Quarzglas, Borosilikatglas, Kalk-Natron-Glas. In einer alternativen bevorzugten Ausgestaltung enthält das Substrat Polymere, besonders bevorzugt Polyethylen, Polypropylen, Polycarbonat, Polymethylmethacrylat und/oder Gemische davon.

Das Substrat weist einen ersten thermischen Ausdehnungskoeffizienten auf. Das Anschlusselement weist einen zweiten thermischen Ausdehnungskoeffizienten auf. Erfindungsgemäß ist die Differenz zwischen dem ersten und dem zweiten Ausdehnungskoeffizienten < 5 x 10⁻⁶/°C. Dadurch wird eine bessere Haftung erhalten.

Auf der Scheibe ist eine elektrisch leitfähige Struktur aufgebracht. Ein elektrisches Anschlusselement ist mit einer Lotmasse auf Teilbereichen mit der elektrisch leitfähigen Struktur elektrisch verbunden. Die Lotmasse tritt mit einer Austrittsbreite von < 1 mm aus dem Zwischenraum zwischen dem Anschlusselement und der elektrisch leitfähigen Struktur aus.

In einer bevorzugten Ausgestaltung ist die maximale Austrittsbreite bevorzugt kleiner 0,5 mm und insbesondere etwa 0 mm. Das ist besonders vorteilhaft im Hinblick auf die Reduzierung von mechanischen Spannungen in der Scheibe, die Haftung des Anschlusselements und die Einsparung des Lots.

Die maximale Austrittsbreite ist definiert als der Abstand zwischen den Außenkanten des Anschlusselementes und der Stelle des Lotmasseübertritts, an dem die Lotmasse eine Schichtdicke von 50 µm unterschreitet. Die maximale Austrittsbreite wird nach dem Lötvorgang an der erstarrten Lotmasse gemessen.

Eine gewünschte maximale Austrittsbreite wird durch eine geeignete Wahl von Lotmassenvolumen und lotrechtem Abstand zwischen Anschlusselement und elektrisch leitfähiger Struktur erreicht, was durch einfache Versuche ermittelt werden kann. Der lotrechte Abstand zwischen Anschlusselement und elektrisch leitfähiger Struktur kann durch ein entsprechendes Prozesswerkzeug, beispielsweise ein Werkzeug mit einem integrierten Abstandshalter, vorgegeben werden.

Die maximale Austrittsbreite kann auch negativ sein, also in den von elektrischem Anschlusselement und elektrisch leitfähiger Struktur gebildeten Zwischenraum zurückgezogen sein.

In einer vorteilhaften Ausgestaltung der erfindungsgemäßen Scheibe ist die maximale Austrittsbreite in dem vom elektrischen Anschlusselement und der elektrisch leitfähigen Struktur gebildeten Zwischenraum in einem konkaven Meniskus zurückgezogen. Ein konkaver Meniskus entsteht beispielsweise durch Erhöhen des lotrechten Abstands zwischen Abstandshalter und leitfähiger Struktur beim Lötvorgang, während das Lot noch flüssig ist.

Der Vorteil liegt in der Reduzierung der mechanischen Spannungen in der Scheibe, insbesondere im kritischen Bereich, der bei einem großen Lotmasseübertritt vorliegt.

Der erste thermische Ausdehnungskoeffizient ist bevorzugt von 8 x 10⁻⁶/°C bis 9 x 10⁻⁶/°C. Das Substrat ist bevorzugt Glas, das bevorzugt einen thermischen Ausdehnungskoeffizienten von 8,3 x 10⁻⁶/°C bis 9 x 10⁻⁶/°C in einem Temperaturbereich von 0 °C bis 300 °C aufweist.

Der zweite thermische Ausdehnungskoeffizient ist bevorzugt von 9 x 10⁻⁶/°C bis 13 x 10⁻⁶/°C, besonders bevorzugt von 10 x 10⁻⁶/°C bis 11,5 x 10⁻⁶/°C in einem Temperaturbereich von 0 °C bis 300 °C.

Die erfindungsgemäße elektrisch leitfähige Struktur weist bevorzugt eine Schichtdicke von 5 µm bis 40 µm, besonders bevorzugt von 5 µm bis 20 µm, ganz besonders bevorzugt von 8 µm bis 15 µm und insbesondere von 10 µm bis 12 µm auf. Die erfindungsgemäße elektrisch leitfähige Struktur enthält bevorzugt Silber, besonders bevorzugt Silberpartikel und Glasfritten.

Die Schichtdicke des Lots ist bevorzugt kleiner oder gleich 6.0 x 10⁻⁴ m, besonders bevorzugt kleiner 3.0 x 10⁻⁴ m.

Die Lotmasse ist bevorzugt bleifrei. Als bleifreie Lotmasse ist im Sinne der Erfindung eine Lotmasse zu verstehen, welche entsprechend der EG-Richtlinie "2002/95/EG zur Beschränkung der Verwendung bestimmter gefährlicher Stoffe in Elektro- und Elektronikgeräten" einen Anteil von kleiner oder gleich 0,1 Gew.-% Blei, bevorzugt kein Blei enthält. Das ist besonders vorteilhaft im Hinblick auf die Umweltverträglichkeit der erfindungsgemäßen Scheibe mit elektrischem Anschlusselement.

Bleifrei Lotmassen weisen typischerweise eine geringere Duktilität auf als bleihaltige Lotmassen, so dass mechanische Spannungen zwischen Anschlusselement und Scheibe weniger gut kompensiert werden können. Es hat sich aber gezeigt, dass kritische mechanische Spannungen durch das erfindungsgemäße Anschlusselement vermieden werden können. Die erfindungsgemäße Lotmasse enthält bevorzugt Zinn und Wismut, Indium, Zink, Kupfer, Silber oder Zusammensetzungen davon. Der Anteil an Zinn in der erfindungsgemäßen Lotzusammensetzung beträgt von 3 Gew.-% bis 99,5 Gew.-%, bevorzugt von 10 Gew.-% bis 95,5 Gew.-%, besonders bevorzugt von 15 Gew.-% bis 60 Gew.-%. Der Anteil an Wismut, Indium, Zink, Kupfer, Silber oder Zusammensetzungen davon beträgt in der erfindungsgemäßen Lotzusammensetzung von 0,5 Gew.-% bis 97 Gew.-%, bevorzugt 10 Gew.-% bis 67 Gew.-%, wobei der Anteil an Wismut, Indium, Zink, Kupfer oder Silber 0 Gew.-% betragen kann. Die erfindungsgemäße Lotzusammensetzung kann Nickel, Germanium, Aluminium oder Phosphor mit einem Anteil von 0 Gew.-% bis 5 Gew.-% enthalten. Die erfindungsgemäße Lotzusammensetzung enthält ganz besonders bevorzugt Bi40Sn57Ag3, Sn40Bi57Ag3, Bi59Sn40Ag1, Bi57Sn42Ag1, In97Ag3, Sn95,5Ag3,8Cu0,7, Bi67In33, Bi33In50Sn17, Sn77,2In20Ag2,8, Sn95Ag4Cu1, Sn99Cu1, Sn96,5Ag3,5, Sn96,5Ag3CuO,5, Sn97Ag3 oder Gemische davon.

In einer vorteilhaften Ausgestaltung enthält die Lotmasse Wismut. Es hat sich gezeigt, dass eine Wismut-haltige Lotmasse zu einer besonders guten Haftung des erfindungsgemäßen Anschlusselements an der Scheibe führt, wobei Beschädigungen der Scheibe vermieden werden können. Der Anteil des Wismuts an der Lotmassenzusammensetzung beträgt bevorzugt von 0,5 Gew.-% bis 97 Gew.-%, besonders bevorzugt von 10 Gew.-% bis 67 Gew.-% und ganz besonders bevorzugt von 33 Gew.-% bis 67 Gew.-%, insbesondere von 50 Gew.-% bis 60 Gew.-%. Die Lotmasse enthält neben Wismut bevorzugt Zinn und Silber oder Zinn, Silber und Kupfer. In einer besonders bevorzugten Ausgestaltung enthält die Lotmasse zumindest 35 Gew.-% bis 69 Gew.-% Wismut, 30 Gew.-% bis 50 Gew.-% Zinn, 1 Gew.-% bis 10 Gew.-% Silber und 0 Gew.-% bis 5 Gew.-% Kupfer. In einer ganz besonders bevorzugten Ausgestaltung enthält die Lotmasse zumindest 49 Gew.-% bis 60 Gew.-% Wismut, 39 Gew.-% bis 42 Gew.-% Zinn, 1 Gew.-% bis 4 Gew.-% Silber und 0 Gew.-% bis 3 Gew.-% Kupfer.

In einer weiteren vorteilhaften Ausgestaltung enthält die Lotmasse von 90 Gew.-% bis 99,5 Gew.-% Zinn, bevorzugt von 95 Gew.-% bis 99 Gew.-%, besonders bevorzugt von 93 Gew.-% bis 98 Gew.-%. Die Lotmasse enthält neben Zinn bevorzugt von 0,5 Gew.-% bis 5 Gew.-% Silber und von 0 Gew.-% bis 5 Gew.-% Kupfer.

Das erfindungsgemäße Anschlusselement enthält bevorzugt zumindest 50 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän und/oder 0 Gew.-% bis 1 Gew.-% Titan. Das Anschlusselement kann zusätzlich Beimengungen weiterer Elemente enthalten, darunter Vanadium, Aluminium, Niob und Stickstoff.

Das erfindungsgemäße Anschlusselement kann auch zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und/oder 0 Gew.-% bis 1 Gew.-% Titan enthalten. Das Anschlusselement kann zusätzlich Beimengungen weiterer Elemente enthalten, darunter Vanadium, Aluminium und Stickstoff.

In einer weiteren bevorzugten Ausgestaltung enthält das erfindungsgemäße Anschlusselement zumindest 65 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1 Gew.-% Molybdän und/oder 0 Gew.-% bis 1 Gew.-% Titan. Das Anschlusselement kann zusätzlich Beimengungen weiterer Elemente enthalten, darunter Vanadium, Aluminium, Niob und Stickstoff.

Das erfindungsgemäße Anschlusselement kann auch zumindest 73 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1 Gew.-% Molybdän, 0 Gew.-% bis 1 Gew.-% Niob und/oder 0 Gew.-% bis 1 Gew.-% Titan enthalten. Das Anschlusselement kann zusätzlich Beimengungen weiterer Elemente enthalten, darunter Vanadium, Aluminium und Stickstoff.

In einer weiteren, besonders bevorzugten Ausgestaltung enthält das erfindungsgemäße Anschlusselement zumindest 75 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan und/oder 0 Gew.-% bis 1 Gew.-% Titan. Das Anschlusselement kann zusätzlich Beimengungen weiterer Elemente enthalten, darunter Vanadium, Aluminium, Niob und Stickstoff.

Das erfindungsgemäße Anschlusselement kann auch zumindest 78,5 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob und/oder 0 Gew.-% bis 1 Gew.-% Titan enthalten. Das Anschlusselement kann zusätzlich Beimengungen weiterer Elemente enthalten, darunter Vanadium, Aluminium und Stickstoff.

Das erfindungsgemäße Anschlusselement ist bevorzugt mit Nickel, Zinn, Kupfer und/oder Silber beschichtet. Das erfindungsgemäße Anschlusselement ist besonders bevorzugt mit einer haftvermittelnden Schicht, bevorzugt aus Nickel und/oder Kupfer, und zusätzlich mit einer lötbaren Schicht, bevorzugt aus Silber, versehen. Das erfindungsgemäße Anschlusselement ist ganz besonders bevorzugt mit 0,1 µm bis 0,3 µm Nickel und/oder 3 µm bis 20 µm Silber beschichtet. Das Anschlusselement kann vernickelt, verzinnt, verkupfert und/oder versilbert werden. Nickel und Silber verbessern die Stromtragfähigkeit und Korrosionsstabilität des Anschlusselements und die Benetzung mit der Lotmasse.

Das erfindungsgemäße Anschlusselement enthält bevorzugt einen chromhaltigen Stahl mit einem Anteil an Chrom von größer oder gleich 10,5 Gew.-% und einem thermischen Ausdehnungskoeffizienten von 9 x 10⁻⁶/°C bis 13 x 10⁻⁶/°C. Weitere Legierungsbestandteile wie Molybdän, Mangan oder Niob führen zu einer verbesserten Korrosionsbeständigkeit oder veränderten mechanischen Eigenschaften, wie Zugfestigkeit oder Kaltumformbarkeit.

Der Vorteil von Anschlusselementen aus chromhaltigem Stahl gegenüber Anschlusselementen nach dem Stand der Technik aus Titan liegt in der besseren Lötbarkeit. Sie ergibt sich aus der höheren Wärmeleitfähigkeit von 25 W/mK bis 30 W/mK im Vergleich zur Wärmeleitfähigkeit des Titans von 22 W/mK. Die höhere Wärmeleitfähigkeit führt zu einer gleichmäßigeren Erwärmung des Anschlusselements während des Lötvorgangs, wodurch die punktuelle Ausbildung besonders heißer Stellen ("hot spots") vermieden wird. Diese Stellen sind Ausgangspunkte für mechanische Spannungen und spätere Beschädigungen der Scheibe. Es ergibt sich eine verbesserte Haftung des Anschlusselements an der Scheibe, insbesondere bei der Verwendung einer bleifreien Lotmasse, die aufgrund ihrer geringeren Duktilität im Vergleich zu bleihaltigen Lotmassen mechanische Spannungen weniger gut kompensieren kann. Aufgrund der besseren Kaltumformbarkeit kann das Anschlusselement auch besser aus dem chromhaltigen Stahl geformt werden. Chromhaltiger Stahl ist zudem besser verfügbar.

Ein weiterer Vorteil von Anschlusselementen aus chromhaltigem Stahl liegt in der hohen Steifigkeit im Vergleich zu vielen herkömmlichen Anschlusselementen, beispielsweise aus Kupfer. Dadurch kann das Anschlusselement weniger leicht verformt werden, beispielsweise unter Belastung durch Zug an einem mit dem Anschlusselement verbundenen Kabel. Eine solche Verformung führt zu einer Belastung der Verbindung zwischen Anschlusselement und elektrisch leitfähiger Struktur über die Lotmasse.

Insbesondere bei bleifreien Lotmassen muss eine solche Belastung vermieden werden. Die Belastung kann infolge der geringeren Duktilität der bleifreien Lotmasse im Vergleich zu bleihaltigen Lotmassen weniger gut kompensiert werden, was zu Beschädigungen der Scheibe führen kann.

Das Anschlusselement ist erfindungsgemäß als Druckknopf ausgebildet. Dadurch kann das Anschlusselement auf einfache und komfortable Weise mit einem Anschlusskabel verbunden werden, wenn das Anschlusskabel mit einem komplementären Druckknopf versehen ist. Das Verbinden des Anschlusselementes mit dem Anschlusskabel kann vorteilhaft nach dem Einbau der Scheibe am Ort der Verwendung erfolgen.

In einer bevorzugten Ausgestaltung ist das Anschlusselement als männlicher Druckknopf ausgebildet. Das Anschlusskabel ist dann mit einem komplementären weiblichen Druckknopf versehen. Das Anschlusselement kann alternativ aber auch als weiblicher Druckknopf ausgebildet und das Anschlusskabel mit einem männlichen Druckknopf versehen sein.

Das Anschlusselement weist zumindest eine Kontaktfläche auf, über die das Anschlusselement bevorzugt vollflächig mittels der Lotmasse mit einem Teilbereich der elektrisch leitfähigen Struktur verbunden ist. Die Kontaktfläche weist bevorzugt keine Ecken auf. Die Kontaktfläche kann beispielsweise eine ovale, elliptische oder runde Form aufweisen. Die Kontaktfläche kann alternativ aber auch eine konvexe polygonale Form, bevorzugt rechteckige Form, mit abgerundeten Ecken aufweisen. Die abgerundeten Ecken weisen einen Krümmungsradius von r > 0.5 mm, bevorzugt von r > 1 mm auf.

Das elektrische Anschlusselement weist bevorzugt zumindest auf der zur Lotmasse ausgerichteten Fläche eine Beschichtung auf, die Kupfer, Zink, Zinn, Silber, Gold oder Legierungen oder Schichten davon, bevorzugt Silber enthält. Dadurch wird eine Ausbreitung der Lotmasse über die Beschichtung hinweg verhindert und die Austrittsbreite begrenzt.

In einer vorteilhaften Ausgestaltung der Erfindung sind auf der Kontaktfläche des Anschlusselements Abstandshalter angeordnet, bevorzugt mindestens zwei Abstandshalter, besonders bevorzugt mindestens drei Abstandshalter. Die Abstandshalter enthalten bevorzugt die gleiche Legierung wie das Anschlusselement. Jeder Abstandshalter ist beispielsweise als Würfel, als Pyramide, als Segment eines Rotationsellipsoids oder als Kugelsegment ausgeformt. Die Abstandshalter haben bevorzugt eine Breite von 0,5 x 10⁻⁴ m bis 10 x 10⁻⁴ m und eine Höhe von 0,5 x 10⁻⁴ m bis 5 x 10⁻⁴ m, besonders bevorzugt von 1x 10⁻⁴ m bis 3 x 10⁻⁴ m. Durch die Abstandshalter wird die Ausbildung einer gleichmäßigen Lotmasseschicht begünstigt. Das ist besonders vorteilhaft in Hinblick auf die Haftung des Anschlusselements. Die Abstandshalter können einstückig mit dem Anschlusselement ausgebildet sein. Die Abstandshalter können beispielsweise durch Umformen eines Anschlusselementes mit im Ausgangszustand planer Kontaktflächen auf der Kontaktfläche ausgebildet werden, beispielsweise durch Prägen oder Tiefziehen. Dabei kann eine entsprechende Vertiefung auf der der Kontaktfläche gegenüberliegenden Oberfläche des Anschlusselements erzeugt werden.

Durch die Abstandshalter wird eine homogene, gleichmäßig dicke und gleichmäßig aufgeschmolzene Schicht der Lotmasse erreicht. Dadurch können mechanische Spannungen zwischen Anschlusselement und Scheibe verringert werden. Das ist insbesondere bei der Verwendung bleifreier Lotmassen besonders vorteilhaft, die aufgrund ihrer geringeren Duktilität im Vergleich zu bleihaltigen Lotmassen mechanische Spannungen weniger gut kompensieren können.

Die Anschlusselemente sind in der Draufsicht beispielsweise bevorzugt von 1 mm bis 50 mm lang und breit und besonders bevorzugt von 3 mm bis 30 mm lang und breit und ganz besonders bevorzugt von 5 mm bis 10 mm lang und breit.

Die Form des elektrischen Anschlusselementes kann Lotdepots im Zwischenraum von Anschlusselement und elektrisch leitfähiger Struktur ausbilden. Die Lotdepots und Benetzungseigenschaften des Lotes am Anschlusselement verhindern den Austritt der Lotmasse aus dem Zwischenraum. Lotdepots können rechtwinklig, verrundet oder polygonal ausgestaltet sein.

Das Einbringen der Energie beim elektrischen Verbinden von elektrischem Anschlusselement und elektrisch leitfähiger Struktur erfolgt bevorzugt mit Stempel, Thermoden, Kolbenlöten, bevorzugt Laserlöten, Heißluftlöten, Induktionslöten, Widerstandslöten und/oder mit Ultraschall.

Die Aufgabe der Erfindung wird weiter durch ein Verfahren zur Herstellung einer erfindungsgemäßen Scheibe mit mindestens einem Anschlusselement gelöst, wobei
a) Lotmasse auf dem Anschlusselement als Plättchen aufgebracht wird,
b) eine elektrisch leitfähige Struktur auf einem Substrat aufgebracht wird,
c) das Anschlusselement mit der Lotmasse auf der elektrisch leitfähigen Struktur angeordnet wird und
d) das Anschlusselement mit der elektrisch leitfähigen Struktur verlötet wird.

Die Lotmasse wird bevorzugt vorher auf die Anschlusselemente appliziert, bevorzugt als Plättchen mit festgelegter Schichtdicke, Volumen, Form und Anordnung auf dem Anschlusselement.

Die Schichtdicke des Lotmasseplättchens beträgt bevorzugt kleiner oder gleich 0,6 mm. Die Form des Lotmasseplättchens entspricht bevorzugt der Form der Kontaktfläche. Ist die Kontaktfläche beispielsweise rund ausgebildet oder eine kreisförmige Außenkante aufweist, so weist das Lotmasseplättchen bevorzugt eine runde Form auf.

Das Anschlusselement wird bevorzugt in Heizscheiben oder in Scheiben mit Antennen in Gebäuden, insbesondere in Automobilen, Eisenbahnen, Flugzeugen oder Seefahrzeugen benutzt. Das Anschlusselement dient dazu, die leitenden Strukturen der Scheibe mit elektrischen Systemen zu verbinden, welche außerhalb der Scheibe angeordnet sind. Die elektrischen Systeme sind Verstärker, Steuereinheiten oder Spannungsquellen.

Die Erfindung wird anhand einer Zeichnung und Ausführungsbeispielen näher erläutert. Es zeigen:
Fig. 1 einen Querschnitt durch eine erste Ausgestaltung der erfindungsgemäßen Scheibe,
Fig. 2 einen Querschnitt durch das Anschlusselement aus Figur 1 in perspektivischer Darstellung,
Fig. 3 ein detailliertes Flussdiagramm des erfindungsgemäßen Verfahrens.

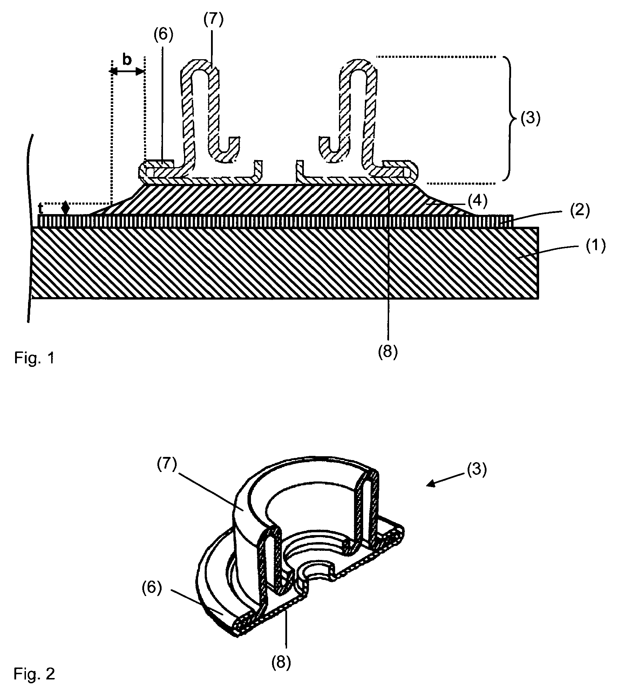

Fig.1 zeigt einen Querschnitt durch eine erfindungsgemäße beheizbare Scheibe 1 im Bereich des elektrischen Anschlusselementes 3. Die Scheibe 1 ist ein 3 mm dickes thermisch vorgespanntes Einscheibensicherheitsglas aus Natron-Kalk-Glas. Die Scheibe 1 weist eine Breite von 150 cm und eine Höhe von 80 cm auf. Auf der Scheibe 1 ist eine elektrisch leitfähige Struktur 2 in Form einer Heizleiterstruktur 2 aufgedruckt. Die elektrisch leitfähige Struktur 2 enthält Silberpartikel und Glasfritten. Im Randbereich der Scheibe 1 ist die elektrisch leitfähige Struktur 2 auf eine Breite von 10 mm verbreitert und bildet eine Kontaktfläche für das elektrische Anschlusselement 3. Im Randbereich der Scheibe 1 befindet sich weiter ein nicht dargestellter Abdecksiebdruck. Im Bereich der Kontaktfläche 8 zwischen dem elektrischen Anschlusselement 3 und der elektrisch leitfähigen Struktur 2 ist Lotmasse 4 aufgebracht, die eine dauerhafte elektrische und mechanische Verbindung zwischen dem elektrischen Anschlusselement 3 und der elektrisch leitfähigen Struktur 2 bewirkt. Die Lotmasse 4 enthält 57 Gew.-% Wismut, 40 Gew.-% Zinn und 3 Gew.-% Silber. Die Lotmasse 4 ist durch ein vorgegebenes Volumen und Form vollständig zwischen dem elektrischen Anschlusselement 3 und der elektrisch leitfähigen Struktur 2 angeordnet. Die Lotmasse 4 hat eine Dicke von 250 µm. Das elektrische Anschlusselement 3 besteht aus Stahl der Werkstoff-Nummer 1.4509 nach EN 10 088-2 (ThyssenKrupp Nirosta® 4509) mit einem thermischen Ausdehnungskoeffizienten von 10,0 x 10⁻⁶/°C. Das Anschlusselement 3 kann eine nicht dargestellte Silberbeschichtung aufweisen, beispielsweise mit einer Dicke von etwa 5 µm.

Stahl der Werkstoff-Nummer 1.4509 nach EN 10 088-2 ist gut kaltumformbar und gut schweißbar mit allen Verfahren außer Gasschweißung. Der Stahl wird für den Bau von Schalldämpfer- und Abgasentgiftungsanlagen eingesetzt und ist dafür aufgrund der Zunderbeständigkeit bis über 950 °C und Korrosionsbeständigkeit gegen die im Abgassystem auftretenden Beanspruchungen besonders geeignet. Es können aber auch andere chromhaltige Stähle für das Anschlusselement 3 verwendet werden. Ein alternativer besonders geeigneter Stahl ist beispielsweise Stahl der Werkstoffnummer 1.4016 nach EN 10 088-2.

Das elektrische Anschlusselement 3 ist als männlicher Druckknopf ausgebildet. In der gezeigten Ausgestaltung besteht das elektrische Anschlusselement 3 aus einer Bodenplatte 6 und einem Verbindungselement 7. Die Bodenplatte 6 weist in der Draufsicht eine Kreisform auf. Die Bodenplatte 6 weist in der Mitte ein kreisförmiges Loch auf, an dessen Außenkante die Bodenplatte 6 nach oben gebogen ist, so dass ein Bereich der Bodenplatte etwa rechtwinklig von der Scheibe 1 weg verläuft. Die äußere Kante der Bodenplatte 6 ist U-förmig umgebogen. Dadurch wird im Randbereich der Bodenplatte 6 eine Aufnahme für das Verbindungselement 7 gebildet. Der umgebogene Randbereich der Bodenplatte 6 kann umlaufend oder unterbrochen ausgestaltet sein. Die Bodenplatte 6 ist mit Ausnahme der umgebogenen Bereiche angrenzend an das Loch und im Randbereich plan ausgeführt. Die plane, der Scheibe 1 zugewandte Fläche der Bodenplatte 6 bildet die Kontaktfläche 8 aus.

Die Bodenplatte 6 weist eine Materialstärke von beispielsweise etwa 0,2 mm oder 0,3 mm auf. Die kreisförmige Außenkante der Bodenplatte 6 weist einen Durchmesser von beispielsweise etwa 8 mm auf. Das kreisförmige Loch in der Mitte der Bodenplatte 6 weist einen Durchmesser von beispielsweise etwa 1 mm auf.

Das Verbindungselement 7 ist im Wesentlichen in der Art eines Hohlzylinders ausgestaltet, der im Wesentlichen senkrecht zur Oberfläche der Scheibe 1 angeordnet ist. Ein Fußbereich an der Außenkante des Verbindungselements 7 ist nach außen umgebogen und erstreckt sich etwa parallel zur Kontaktfläche 8 von dem Hohlzylinder weg. Dieser Fußbereich ist in die Aufnahme eingesteckt, die durch den umgebogenen Randbereich der Bodenplatte 6 ausgebildet wird. Dadurch ist das Verbindungselement 7 dauerhaft stabil mit der Bodenplatte 6 zum Anschlusselement 3 verbunden. Die Wände des Hohlzylinders sind durch eine etwa U-förmige Umbiegung des Verbindungselements 7 realisiert, wobei der Radius der U-förmigen Umbiegung beispielsweise etwa 0,3 mm beträgt. Der Hohlzylinder weist einen äußeren Durchmesser von beispielsweise etwa 5,7 mm und einen inneren Durchmesser von beispielsweise etwa 3,5 mm auf. Die Materialstärke des Verbindungselements 7 beträgt beispielsweise etwa 0,3 mm. Die Höhe des Verbindungselements 7 beträgt beispielsweise etwa 3,5 mm.

Das Anschlusselement 3 ist dafür vorgesehen und geeignet, mit einem nicht dargestellten weiblichen Druckknopf verbunden zu werden. Der weibliche Druckknopf wird dazu auf das Verbindungselement 7 aufgesteckt. Die Außenwand des Hohlzylinders führt nicht senkrecht von der Scheibe 1 weg, sondern weist einen Winkel von beispielsweise etwa 3° zu Senkrechten auf, so dass das der Durchmesser des Verbindungselements 7 mit wachsendem Abstand zur Scheibe 1 leicht größer wird. Dadurch wird ein unbeabsichtigtes Abrutschen des aufgesteckten weiblichen Druckknopfes vermieden. Der weibliche Druckknopf kann beispielsweise Federelemente umfassen, die einen Druck auf die Außenwände des Verbindungselements 7 ausüben. An den weiblichen Druckknopf ist ein Anschlusskabel zur Bordelektrik angeschlossen. So kann sehr einfach und komfortabel eine elektrische Verbindung zwischen der elektrisch leitfähigen Struktur 2 und der externen Spannungsquelle bereitgestellt werden.

Das Verbindungselement 7 kann alternativ beispielsweise mit einer Furche versehen sein, in die eine Lippe des weiblichen Druckknopfes beim Aufstecken einrastet. Wenn der Durchmesser des Verbindungselements 7 zumindest in einem Teilbereich seiner Höhe mit wachsendem Abstand zur Scheibe 1 größer wird, so kann der weibliche Druckknopf vorteilhaft auf dem männlichen Druckknopf einrasten, beispielsweise mittels Lippen oder Federelementen.

Fig. 2 zeigt einen Querschnitt durch das Anschlusselement 3 aus Figur 1 in perspektivischer Darstellung. Das Anschlusselement 3 umfasst die Bodenplatte 6 mit der Kontaktfläche 8 und das Verbindungselement 7.

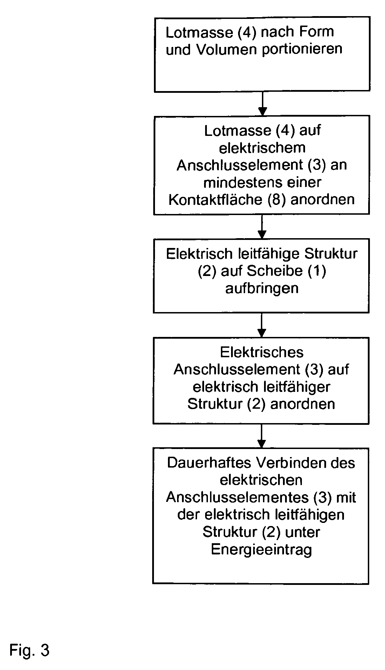

Fig. 3 zeigt detailliert ein erfindungsgemäßes Verfahren zur Herstellung einer Scheibe 1 mit elektrischem Anschlusselement 3. Dort wird ein Beispiel für das erfindungsgemäße Verfahren zur Herstellung einer Scheibe mit einem elektrischen Anschlusselement 3 dargestellt. Als erster Schritt ist es notwendig, die Lotmasse 4 nach Form und Volumen zu portionieren. Die portionierte Lotmasse 4 wird auf die Kontaktfläche 8 des elektrischen Anschlusselementes 3 angeordnet. Die Lotmasse 4 kann beispielsweise als kreisförmiges Plättchen geformt werden das auf der Kontaktfläche des Anschlusselements 3 aus Figur ein angeordnet wird, wobei das Loch in der Mitte der Bodenplatte 6 abgedeckt wird. Das elektrische Anschlusselement 3 wird mit der Lotmasse 4 auf der elektrisch leitfähigen Struktur 2 angeordnet. Es erfolgt eine dauerhafte Verbindung des elektrischen Anschlusselementes 3 mit der elektrisch leitfähigen Struktur 2 und dadurch mit der Scheibe 1 unter Energieeintrag.

### Beispiel

Testproben wurden angefertigt mit der Scheibe 1 (Dicke 3 mm, Breite 150 cm und Höhe 80 cm), der elektrisch leitfähigen Struktur 2 in Form einer Heizleiterstruktur, dem elektrischen Anschlusselement 3 gemäß Figur 1 und der Lotmasse 4. Das Anschlusselement 3 war versilbert. Die Lotmasse 4 wurde vorher als kreisförmiges Plättchen mit festgelegter Schichtdicke, Volumen und Form auf der Kontaktfläche 8 des Anschlusselements 3 aufgebracht. Das Anschlusselement 3 wurde mit der angebrachten Lotmasse 4 auf der elektrisch leitfähigen Struktur 2 angebracht. Das Anschlusselement 3 wurde bei einer Temperatur von 200 °C und einer Behandlungsdauer von 2 Sekunden auf der elektrisch leitfähigen Struktur 2 angelötet. Ein Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde nur auf einer maximalen Austrittsbreite von b = 0,5 mm beobachtet. Die Zusammensetzungen des elektrischen Anschlusselements 3 und der Lotmasse 4 gehen aus der Tabelle 1 hervor. Durch die Anordnung der Lotmasse 4, vorgegeben durch das Anschlusselement 3 und die elektrisch leitfähige Struktur 2, wurden keine kritischen mechanischen Spannungen in der Scheibe 1 beobachtet. Die Verbindung der Scheibe 1 mit dem elektrischen Anschlusselement 3 war über die elektrisch leitfähige Struktur 2 dauerhaft stabil.

Bei sämtlichen Proben konnte bei einem Temperaturunterschied von +80 °C auf -30 °C beobachtet werden, dass kein Glassubstrat 1 brach oder Schäden aufwies. Es konnte gezeigt werden, dass kurz nach dem Anlöten diese Scheiben 1 mit angelöteten Anschlusselement 3 gegen plötzlichen Temperaturabfall stabil waren.

**Tabelle 1**

| Bestandteile | Material | Beispiel |
|---|---|---|
| Anschlusselement 3 | | |
| | Stahl der Werkstoff-Nummer 1.4509 nach EN 10 088-2 mit der Zusammensetzung: | |
| | Eisen (Gew.-%) | 78,87 |
| | Kohlenstoff (Gew.-%) | 0,03 |
| | Chrom (Gew.-%) | 18,5 |
| | Titan (Gew.-%) | 0,6 |
| | Niob (Gew.-%) | 1 |
| | Mangan (Gew.-%) | 1 |
| | CTE (coefficient of thermal expansion) (10⁻⁶/°C für 0 °C - 100 °C) | 10 |
| | Differenz zwischen CTE Anschlusselement und Substrat (10⁻⁶/°C für 0 °C - 100 °C) | 1,7 |
| | Wärmeleitfähigkeit (W/mK für 20 °C) | 25 |
| Lotmasse 4 | | |
| | Zinn (Gew.-%) | 40 |
| | Wismut (Gew.-%) | 57 |
| | Silber (Gew.-%) | 3 |
| | Dicke der Lotschicht in (m) | 250 x 10⁻⁶ |
| Glas Substrat 1 | | |
| (Natron-Kalk-Glas) | | |
| | CTE (10⁻⁶/°C für 0 °C - 320 °C) | 8,3 |

### Vergleichsbeispiel

Das Vergleichsbeispiel wurde genauso durchgeführt wie das Beispiel. Der Unterschied lag in der Verwendung eines anderen Materials für das Anschlusselement 3. Das Anschlusselement 3 bestand zu 100 Gew.-% aus Titan. Das Anschlusselement 3 hatte damit eine geringere Wärmeleitfähigkeit, einen geringeren thermischen Ausdehnungskoeffizienten und einen geringeren Unterschied der thermischen Ausdehnungskoeffizienten zwischen Anschlusselement 3 und Substrat 1. Die Bestandteile des elektrischen Anschlusselements 3 und der Lotmasse 4 gehen aus der Tabelle 2 hervor. Das Anschlusselement 3 wurde mit der elektrisch leitfähigen Struktur 2 nach herkömmlichen Verfahren mittels der Lotmasse 4 verlötet. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 2 mm bis 3 mm erhalten. Die geringere Wärmeleitfähigkeit des Materials für das Anschlusselement 3 führte im Vergleichsbeispiel zu einer weniger gleichmäßigen Erwärmung des Anschlusselements während des Lötvorgangs.

Bei einem plötzlichen Temperaturunterschied von +80 °C auf -30 °C wurde beobachtet, dass die Glassubstrate 1 kurz nach dem Anlöten überwiegend Schäden aufwiesen.

**Tabelle 2**

| Bestandteile | Material | Vergleichsbeispiel |
|---|---|---|
| Anschlusselement 3 | | |
| | Titan (Gew.-%) | 100 |
| | CTE (coefficient of thermal expansion) (10⁻⁶/°C für 0 °C - 100 °C) | 8,80 |
| | Differenz zwischen CTE des Anschlusselements und des Substrats (10⁻⁶/°C für 0 °C - 100 °C) | 0,5 |
| | Wärmeleitfähigkeit (W/mK für 20 °C) | 22 |
| Lotmasse 4 | | |
| | Zinn (Gew.-%) | 40 |
| | Wismut (Gew.-%) | 57 |
| | Silber (Gew.-%) | 3 |
| | Dicke der Lotschicht in (m) | 250 x 10⁻⁶ |
| Glas Substrat 1 | | |
| (Natron-Kalk-Glas) | | |
| | CTE (10⁻⁶/°C für 0 °C - 320 °C) | 8,3 |

Die Unterschiede aus den vorstehenden Tabellen 1 und 2 und die Vorteile des erfindungsgemäßen Anschlusselementes 3 gehen aus der Tabelle 3 hervor.

**Tabelle 3**

| | Erfindungsgemäße Ausführung, Beispiel | Vergleichsbeispiel |
|---|---|---|
| Material | Stahl der Werkstoff-Nummer 1.4509 nach EN 10 088-2 | Titan |
| Wärmeleitfähigkeit (W/mK für 20°C) | 25 | 22 |
| CTE (coefficient of thermal expansion) des Anschlusselements (10⁻⁶/°C für 0 °C - 100 °C) | 10 | 8,8 |
| Differenz zwischen CTE des Anschlusselements und des Substrats (10⁻⁶/°C für 0 °C - 100 °C) | 1,7 | 0,5 |

Es hat sich gezeigt, dass erfindungsgemäße Scheiben mit Glassubstraten 1 und erfindungsgemäßen elektrischen Anschlusselementen 3 eine bessere Stabilität gegen plötzliche Temperaturunterschiede aufwiesen. Dieses Ergebnis war für den Fachmann unerwartet und überraschend.

### Bezugszeichenliste

- (1): Scheibe
- (2): Elektrisch leitfähige Struktur
- (3): Elektrisches Anschlusselement
- (4): Lotmasse
- (5): Benetzungsschicht
- (6): Bodenplatte des elektrischen Anschlusselements 3
- (7): Verbindungselement des elektrischen Anschlusselements 3
- (8): Kontaktfläche des Anschlusselements 3 mit der elektrisch leitfähigen Struktur 2

- b: maximale Austrittsbreite der Lotmasse
- t: Grenzdicke der Lotmasse

## Patentansprüche

1. Eine Scheibe mit mindestens einem elektrischen Anschlusselement, umfassend:
- ein Substrat (1),
- eine elektrisch leitfähige Struktur (2) auf einem Bereich des Substrats (1),
- ein Anschlusselement (3), welches als Druckknopf ausgebildet ist und einen chromhaltigen Stahl enthält, und
- eine Schicht einer Lotmasse (4), die das Anschlusselement (3) zumindest mit einem Teilbereich der elektrisch leitfähigen Struktur (2) elektrisch verbindet,
wobei das Substrat (1) Kalk-Natron-Glas enthält, wobei die Differenz zwischen dem thermischen Ausdehnungskoeffizienten des Substrats (1) und dem thermischen Ausdehnungskoeffizienten des Anschlusselements (3) < 5 x 10⁻⁶/°C ist.

2. Scheibe nach Anspruch 1, wobei das Anschlusselement (3) zumindest 50 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän oder 0 Gew.-% bis 1 Gew.-% Titan enthält.

3. Scheibe nach Anspruch 2, wobei das Anschlusselement (3) zumindest 75 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan oder 0 Gew.-% bis 1 Gew.-% Titan enthält.

4. Scheibe nach einem der Ansprüche 1 bis 3, wobei die elektrisch leitfähige Struktur (2) Silber enthält.

5. Scheibe nach einem der Ansprüche 1 bis 4, wobei die Schichtdicke der Lotmasse (4) kleiner oder gleich 6.0 x 10⁻⁴ m ist.

6. Scheibe nach einem der Ansprüche 1 bis 5, wobei die Lotmasse (4) Zinn und Wismut, Indium, Zink, Kupfer, Silber oder Zusammensetzungen davon enthält.

7. Scheibe nach Anspruch 6, wobei der Anteil an Zinn in der Lotzusammensetzung (4) 3 Gew.-% bis 99,5 Gew.-% beträgt und der Anteil von Wismut, Indium, Zink, Kupfer, Silber oder Zusammensetzungen davon 0,5 Gew.-% bis 97 Gew.-% beträgt.

8. Scheibe nach einem der Ansprüche 1 bis 7, wobei das Anschlusselement (3) mit Nickel, Zinn, Kupfer und/oder Silber beschichtet ist.

9. Scheibe nach Anspruch 8, wobei das Anschlusselement (3) mit 0,1 µm bis 0,3 µm Nickel und/oder 3 µm bis 20 µm Silber beschichtet ist.

10. Scheibe nach einem der Ansprüche 1 bis 9, wobei das Anschlusselement (3) über eine Kontaktfläche (8) vollflächig mit dem Teilbereich der elektrisch leitfähigen Struktur (2) verbunden ist.

11. Scheibe nach Anspruch 10, wobei die Kontaktfläche (8) keine Ecken aufweist.

12. Verfahren zur Herstellung einer Scheibe mit mindestens einem elektrischen Anschlusselement nach einem der Ansprüche 1 bis 11, wobei
a) Lotmasse (4) auf dem Anschlusselement (3) als Plättchen aufgebracht wird,
b) eine elektrisch leitfähige Struktur (2) auf einem Substrat (1) aufgebracht wird,
c) das Anschlusselement (3) mit der Lotmasse (4) auf der elektrisch leitfähigen Struktur (2) angeordnet wird und
d) das Anschlusselement (3) mit der elektrisch leitfähigen Struktur (2) verlötet wird.

13. Verwendung einer Scheibe mit mindestens einem elektrischen Anschlusselement nach einem der Ansprüche 1 bis 11, für Fahrzeuge mit elektrisch leitfähigen Strukturen, bevorzugt mit Heizleitern und/oder Antennenleitern.

## Claims

1. A pane with at least one electrical connection element, comprising:
- a substrate (1),
- an electrically conductive structure (2) on a region of the substrate (1),
- a connection element (3) that is implemented as a snap and contains a chromium-containing steel, and
- a layer of a soldering compound (4), which electrically connects the connection element (3) at least to a subregion of the electrically conductive structure (2),
wherein the substrate (1) contains soda lime glass, wherein the difference between the coefficient of thermal expansion of the substrate (1) and the coefficient of thermal expansion of the connection element (3) is < 5 x 10⁻⁶/°C.

2. Pane according to claim 1, wherein the connection element (3) contains at least 50 wt.-% to 89.5 wt.-% iron, 10.5 wt.-% to 20 wt.-% chromium, 0 wt.-% to 1 wt.-% carbon, 0 wt.-% to 5 wt.-% nickel, 0 wt.-% to 2 wt.-% manganese, 0 wt.-% to 2.5 wt.-% molybdenum, or 0 wt.-% to 1 wt.-% titanium.

3. Pane according to claim 2, wherein the connection element (3) contains at least 75 wt.-% to 84 wt.-% iron, 16 wt.-% to 18.5 wt.-% chromium, 0 wt.-% to 0.1 wt.-% carbon, 0 wt.-% to 1 wt.-% manganese, or 0 wt.-% to 1 wt.-% titanium.

4. Pane according to one of claims 1 through 3, wherein the electrically conductive structure (2) contains silver.

5. Pane according to one of claims 1 through 4, wherein the layer thickness of the soldering compound (4) is less than or equal to 6.0 x 10⁻⁴ m.

6. Pane according to one of claims 1 through 5, wherein the soldering compound (4) contains tin and bismuth, indium, zinc, copper, silver, or compositions thereof.

7. Pane according to claim 6, wherein the proportion of tin in the solder composition (4) is 3 wt.-% to 99.5 wt.-% and the proportion of bismuth, indium, zinc, copper, silver, or compositions thereof is 0.5 wt.-% to 97 wt.-%.

8. Pane according to one of claims 1 through 7, wherein the connection element (3) is coated with nickel, tin, copper, and/or silver.

9. Pane according to claim 8, wherein the connection element (3) is coated with 0.1 µm to 0.3 µm nickel and/or 3 µm to 20 µm silver.

10. Pane according to one of claims 1 through 9, wherein the connection element (3) is connected to the subregion of the electrically conductive structure (2) via a contact surface (8) over its entire surface.

11. Pane according to claim 10, wherein the contact surface (8) has no corners.

12. Method for producing a pane with at least one electrical connection element according to one of claims 1 through 11, wherein
a) soldering compound (4) is applied on the connection element (3) as a platelet,
b) an electrically conductive structure (2) is applied on a substrate (1),
c) the connection element (3) with the soldering compound (4) is arranged on the electrically conductive structure (2), and
d) the connection element (3) is soldered to the electrically conductive structure (2).

13. Use of a pane with at least one electrical connection element according to one of claims 1 through 11, for motor vehicles with electrically conductive structures, preferably with heating conductors and/or antenna conductors.

## Revendications

1. Une vitre avec au moins un élément de connexion électrique comprenant:
- un substrat (1),
- une structure électriquement conductrice (2) sur une zone du substrat (1),
- un élément de connexion (3), qui est configuré comme bouton-poussoir et contient un acier contenant du chrome, et
- une couche d'une masse de soudure (4), qui relie l'élément de connexion (3) électriquement avec au moins une zone partielle de la structure électriquement conductrice (2), où le substrat contient du verre sodocalcique (1), où la différence entre le coefficient de dilatation thermique du substrat (1) et le coefficient de dilatation thermique de l'élément de connexion (3) est <5x10⁻⁶/°C.

2. Vitre selon la revendication 1, où l'élément de connexion contient au moins 50% à 89,5% en poids de fer, 10% à 20% en poids de chrome, 0% à 1 % en poids de carbone, 0% à 5% en poids de nickel, 0% à 2% en poids de manganèse, 0% à 2,5% en poids de molybdène ou 0% à 1% en poids de titane.

3. Vitre selon la revendication 1, où l'élément de connexion (3) contient au moins 75% à 84% en poids de fer, 16% à 18,5% en poids de chrome, 0% à 0,1% en poids de carbone, 0% à 1% en poids de manganèse, 0% à 1% en poids de titane.

4. Vitre selon l'une des revendications 1 à 3, la structure électriquement conductrice (2) contient de l'argent.

5. Vitre selon l'une des revendications 1 à 4, où l'épaisseur de la masse de soudure (4) est inférieure ou égale à 6,0 x 10⁻⁴m. »

6. Vitre selon l'une des revendications 1 à 5, où la masse de soudure (4) contient de l'étain et du bismuth, de l'indium, du zinc, du cuivre, de l'argent ou des combinaisons de ceux-ci.

7. Vitre selon la revendication 6, où la part d'étain dans la masse de soudure est de 3% à 99,5% en poids et la part de bismuth, indium, zinc, cuivre, l'argent ou des ou des combinaisons de ceux-ci est de 0,5% à 97,5% en poids.

8. Vitre selon l'une des revendications 1 à 7, où l'élément de connexion (3) est recouvert de nickel, étain, cuivre ou argent.

9. Vitre selon la revendication 8, où l'élément de connexion (3) est recouvert de 0,1 µm à 0,3 µm de nickel et/ou de 3 µm à 20 µm d'argent.

10. Vitre selon l'une des revendications 1 à 9, où l'élément de connexion (3) est relié sur toute la surface par le biais d'une surface de contact (8) avec une partie de la structure électriquement conductrice (2).

11. Vitre selon la revendication 10, où la surface de contact (8) ne comprend aucun angle.

12. Procédé de fabrication d'une vitre avec au moins un élément de connexion électrique selon l'une des revendications 1 à 11, où
a) une masse de soudure (4) est appliquée sur l'élément de connexion (3) sous forme d'une plaquette,
b) une structure électriquement conductrice (2) est appliquée sur un substrat (1),
c) l'élément de connexion (3) est disposé avec la masse de soudure (4) sur la structure électriquement conductrice (2) et
d) l'élément de connexion (3) est soudé avec la structure électriquement conductrice (2).

13. Utilisation d'une vitre avec au moins un élément de connexion électrique selon l'une des revendications 1 à 11, pour des véhicules avec des structures électriquement conductrices, de préférence avec des conducteurs électriques chauffants ou des conducteurs d'antenne.
